# EUROPÄISCHE PATENTSCHRIFT

(11) **EP 1 516 196 B1**
(45) Veröffentlichungstag und Bekanntmachung des Hinweises auf die Patenterteilung: **10.08.2005**
(21) Anmeldenummer: 03740361.5
(22) Anmeldetag: 26.06.2003
(51) Int. Cl.: G01R 31/36, H02J 7/00

(54) **EINRICHTUNG UND VERFAHREN ZUM BESTIMMEN EINES LADEZUSTANDS EINER BATTERIE**
DEVICE AND METHOD FOR DETERMINING A CHARGED STATE OF A BATTERY
DISPOSITIF ET PROCEDE DE DETERMINATION D'UN ETAT DE CHARGE D'UNE BATTERIE

(30) Priorität: 27.06.2002 DE 10228806
(43) Veröffentlichungstag der Anmeldung: 23.03.2005
(73) Patentinhaber: Fraunhofer-Gesellschaft zur Förderung der angewandten Forschung e.V., 80686 München (DE)
(72) Erfinder: SPIES, Peter, 91047 Herzogenaurach (DE); OVERBECK, Matthias, 91058 Erlangen (DE); ROHMER, Günter, 91058 Erlangen (DE); KORDAS, Norbert, 59368 Werne (DE); KAPPERT, Holger, 45239 Essen (DE)
(74) Vertreter: Schoppe, Fritz, Dipl.-Ing.
(86) Internationale Anmeldenummer: PCT/EP2003/006797
(87) Internationale Veröffentlichungsnummer: WO 2004/003584

(56) Entgegenhaltungen:
- WO-A-01/18899
- US-A- 4 012 681
- US-A- 6 157 169
- US-B1- 6 232 747
- PATENT ABSTRACTS OF JAPAN vol. 1997, no. 10, 31. Oktober 1997 (1997-10-31) & JP 09 171065 A (SEIKO EPSON CORP), 30. Juni 1997 (1997-06-30)
- PATENT ABSTRACTS OF JAPAN vol. 1999, no. 13, 30. November 1999 (1999-11-30) & JP 11 223665 A (NISSAN MOTOR CO LTD), 17. August 1999 (1999-08-17)

## Beschreibung

Die vorliegende Erfindung bezieht sich auf Erfassungseinrichtungen zum Erfassen elektrischer Parameter und spezifischer auf Einrichtungen zum Bestimmen eines Ladezustands einer Batterie.

Viele elektrische Geräte verwenden heutzutage eine Batterie als Leistungsquelle, um eine tragbare Handhabung zu gewährleisten. Um ein sicheres Betreiben dieser Geräte zu erreichen und ferner ungenügende Versorgungszustände der mit der Batterie verbundenen Verbraucher zu vermeiden, ist es notwendig, den Ladezustand der Batterien genau zu erfassen. Das Erfassen des Ladezustands ermöglicht das Erkennen eines unzureichenden Ladezustands der Batterie, bei dem das Liefern einer ausreichenden Stroms- oder einer ausreichenden Spannung nicht mehr oder nur noch eingeschränkt gewährleistet ist. Bei Erkennen eines solchen unzureichenden Ladungszustands können geeignete Maßnahmen, beispielsweise ein Aufladen der Batterie, durchgeführt werden, um eine weitere Versorgung des Verbrauchers sicherzustellen.

Bei bekannten Batteriemodulen wird eine Ladungskapazität durch Bestimmen eines Ladestroms und eines Entladestroms ermittelt. Dabei wird typischerweise in dem Lade- und Entladestromkreis ein Spannungsabfall an ohmschen Widerständen gemessen, der proportional zu dem durchfließenden Strom ist, wodurch mit Hilfe der Lade- bzw. Entladezeit die Ladungsmenge berechnet werden kann. Bekannterweise wird der Wert der auf die Batterie fließenden und von der Batterie abgegebenen Ladungsmenge zur Restkapazitätsbestimmung in unterschiedlichen Speicher-Registern gespeichert. Diese Werte können mit einer Temperaturabhängigkeit der Batteriekapazität und dem Selbstentladestrom in Abhängigkeit der Temperatur korrigiert werden.

Bei diesem bekannten Verfahren ist es erforderlich, daß sowohl der Ladestrom als auch der Entladestrom ständig gemessen und gezählt wird. Dies bedeutet, daß Elektronikkomponenten, die zum Erfassen der Ströme verwendet werden, wie beispielsweise ein Multiplexer und ein Analog-Digital-Wandler (ADC = Analog-Digital-Converter), permanent aktiv bleiben. Da diese Komponenten typischerweise selbst mit der Batterie verbunden sind, weist dieses Verfahren den Nachteil auf, daß die Batterie einer erhöhten Leistungsentnahme ausgesetzt ist, da die ständig aktiven Elektronikkomponenten selbst einen Eigen-Versorgungsstrom benötigen und somit die Restkapazität der Batterie verringern. Dies wirkt sich insbesondere bei Batterien mit geringer Gesamtladungskapazität nachteilig aus, bei denen bereits eine geringe Erhöhung der entnommenen Leistung zu einer starken Verringerung der Betriebszeit führt.

US-B1-6 232 747 offenbart ein Verfahren zum Erfassen eines Ladungszustands einer Batterie, bei dem eine Ausgangsspannung und ein Ausgangsstrom, die einem Betriebszustand entsprechen, gemessen werden. Die erfaßten Spannungs- und Stromwerte werden daraufhin verwendet, um eine interne elektromotorische Spannung zu berechnen. Dieser Parameter wird verwendet, um die verbleibende Zeit der Batterie zu bestimmen. Ferner wird es bestimmt, ob sich ein Betriebsmodus verändert. Bei einer Änderung des Betriebsmodus wird eine Zeitgebungseinrichtung zurückgesetzt, der Betriebsmodus wird identifiziert und aus den gemessenen Werten der Spannung und des Stroms wird eine Leerlaufspannung bestimmt, wobei sich durch Vergleichen der bestimmten Leerlaufspannung mit einer Kennlinie der Batterie eine verbleibende Kapazität der Batterie bestimmen lässt. Bei dem US-B1-6 232 747 wird jedoch weder eine Zeit erfasst noch eine Zeit bei der Berechnung eines Ladungszustands verwendet. Es ist somit bei diesem Verfahren nicht möglich, während der Zeitspanne zwischen den Änderungen des Betriebsmodus eine genaue Angabe hinsichtlich der verbleibenden Batteriekapazität zu erhalten.

Die Aufgabe der vorliegenden Erfindung besteht darin, eine Vorrichtung zu schaffen, die eine genauere Bestimmung einer Batterie-Ladungskapazität ermöglicht.

Diese Aufgabe wird durch eine Einrichtung nach Anspruch 1 und ein Verfahren nach Anspruch 17 gelöst.

Die vorliegende Erfindung schafft eine Einrichtung zum Bestimmen eines Ladezustands einer Batterie, mit folgenden Merkmalen:
einer Einrichtung zum Erfassen eines Betriebszustands eines Verbrauchers und zum Erzeugen eines den Betriebszustand darstellenden Signals;
einer Strommeßeinrichtung zum Erfassen eines elektrischen Stroms von der Batterie zu dem Verbraucher;
einer Steuereinrichtung zum Ansteuern der Strommeßeinrichtung, der das den Betriebszustand darstellende Signal zugeführt wird, welche die Strommeßeinrichtung lediglich dann zum Erfassen des elektrischen Stroms aktiviert, wenn das den Betriebszustand darstellende Signal eine Änderung des Betriebszustands angibt; und
einer Auswerteeinrichtung, die den Ladezustand der Batterie aufgrund des von der Strommeßeinrichtung erfaßten elektrischen Stroms und der zwischen jeweiligen Betriebszustandsänderungen verstrichenen Zeit ermittelt.

Ferner schafft die vorliegende Erfindung ein Verfahren zum Bestimmen eines Ladezustands einer Batterie mit folgenden Schritten:
Erfassen eines Betriebszustands eines Verbrauchers und Erzeugen eines den Betriebszustand darstellenden Signals;
Durchführen eines Erfassens eines elektrischen Stroms von der Batterie zu dem Verbraucher lediglich, wenn das den Betriebszustand darstellende Signal eine Änderung des Betriebszustands angibt; und
Ermitteln des Ladezustands der Batterie aufgrund des von der Strommeßeinrichtung erfaßten elektrischen Stroms und der zwischen jeweiligen Betriebszustandsänderungen verstrichenen Zeit.

Die vorliegende Erfindung basiert auf der Erkenntnis, daß eine verlustleistungsarme Ladekapazitätsbestimmung durch eine nicht-kontinuierliche Stromerfassung erreicht wird, bei der ein elektrischer Strom von der Batterie zu einem Verbraucher lediglich dann erfaßt, wenn sich ein Betriebszustand des Verbrauchers oder einer Verbraucherkomponente ändert. Zur erfindungsgemäßen Bestimmung des Ladezustands der Batterie ist es lediglich erforderlich, die zwischen aufeinanderfolgenden Betriebszustandsänderungen verstrichene Zeitdauer zu bestimmen, da der Versorgungsstrom während eines beibehaltenen Betriebszustands im wesentlichen konstant ist.

Dadurch sind die zu der Ladungszustandsbestimmung erforderlichen Schaltungsteile über lange Zeiträume inaktiv und werden lediglich zu ganz bestimmten Zeiten aktiviert, um den geänderten Versorgungsstrom zu messen, so daß sich ein geringer Eigenverbrauch an elektrischer Leistung ergibt. Dies ermöglicht eine Restkapazitätsbestimmung selbst bei sehr geringen Batteriekapazitäten. Ferner wird dadurch eine lange Betriebszeit der Batterie erreicht.

Bei einem Ausführungsbeispiel wird für jeden Betriebszustand die Größe des erfaßten Stroms gespeichert, so daß es bei einem erneuten Auftreten desselben Betriebszustands nicht mehr erforderlich ist, den von dem Verbraucher entnommenen Strom zu erfassen. Dies reduziert die bei der Restkapazitätserfassung entstehende Verlustleistung der Batterie noch weiter.

Bei vielen Anwendungen werden Verbraucher typischerweise über eine Steuerungseinrichtung gesteuert. Dies ermöglicht bei einem Ausführungsbeispiel eine einfache Erfassung einer Betriebszustandsänderung des Verbrauchers, indem das Steuersignal der Steuerungseinrichtung zur Erfassung der Betriebszustandsänderung verwendet wird. Bei einem Ausführungsbeispiel ist die Einrichtung zum Erfassen eines Betriebszustands eine Leistungs-Verwaltungs-Einheit (Power-Management-Einheit), die über eine Bus-Leitung Betriebszustandsinformationen an die Steuereinrichtung weiterleitet. Dies ermöglicht, daß die Kommunikation zwischen der Leistungs-Verwaltungs-Einheit und der Steuereinrichtung mittels bekannter und standardisierter Einrichtungen durchgeführt wird. Da die Leistungs-Verwaltungs-Einheit typischerweise bereits ein Bus-System aufweist, werden bei diesem Ausführungsbeispiel Kosten gering gehalten.

Bei einem Ausführungsbeispiel umfaßt der Verbraucher einen Sendeempfänger. In einem ersten Betriebszustand ist bei dem Sendeempfänger eine Empfangsschaltung aktiv geschaltet, während in einem zweiten Betriebszustand eine Sendeschaltung aktiviert ist. Bei diesem Ausführungsbeispiel steuert die Leistungs-Verwaltungs-Einheit ferner eine Verstärkung der Empfangs- und der Sendeschaltung abhängig von einem empfangenen Signalpegel. Dadurch wird der Versorgungsstrom für den Sendeempfänger abhängig von den aktiv geschalteten Komponenten und den jeweiligen Verstärkungswerten bestimmt. Hierbei wird jedesmal, wenn eine Aktivierung bzw. Deaktivierung der Komponenten erfolgt, oder wenn eine Umschaltung der Verstärkung einer Komponente durchgeführt wird, eine Meldung durch die Leistungs-Verwaltungs-Einheit zu der Steuereinrichtung zum Ansteuern der Strommeßeinrichtung ausgegeben, um eine kurzzeitige Strommessung für den jeweiligen Betriebszustand durchzuführen.

Bei anderen Ausführungsbeispielen werden neben dem Verbraucherstrom weitere Batterieparameter vorzugsweise in kurzen Zeitintervallen aufeinanderfolgend erfaßt. Diese Parameter umfassen beispielsweise die Temperatur der Batterie und eine Klemmenspannung. Zusätzlich wird bei einem Ausführungsbeispiel, bei dem die Batterie eine wiederaufladbare Batterie ist, während des Ladens der Batterie der Ladestrom erfaßt.

Bei einem alternativen Ausführungsbeispiel ist ferner eine Einrichtung vorgesehen, um bei einer niedrigen Restkapazität eine Leistungs-Verwaltung anzuweisen, auf eine Ausführung weniger wichtiger Funktionen oder Aufgaben zu verzichten und lediglich die wichtigsten Funktionen zu gewährleisten. Dadurch wird in dem Fall einer niedrigen Restkapazität Energie gespart, wodurch eine mögliche Betriebszeit verlängert wird.

Bei einem noch weiteren Ausführungsbeispiel kann bei einer zu hohen Betriebstemperatur der Batterie die Leistungs-Verwaltung oder eine Systemsteuerung veranlaßt werden, geeignete Maßnahmen zur Vermeidung nachteiliger Störungen oder Beschädigungen der Batterie durchzuführen.

Alternativ kann ein Ausführungsbeispiel ein Umschalten von dem erfindungsgemäßen nicht-kontinuierlichen Strommessen zu dem bekannten permanenten Erfassen des Stroms aufweisen. In dem letztgenannten Modus kann ein Bestimmten eines Ladezustands der Batterie auch ohne Erfassen des Betriebszustands durchgeführt werden. Dies ermöglicht eine flexible Handhabung.

Bevorzugte Ausführungsbeispiele der vorliegenden Erfindung werden nachfolgend Bezug nehmend auf die beiliegenden Zeichnungen näher erläutert. Es zeigen:
- Fig. 1: ein Blockschaltbild eines Ausführungsbeispiels der vorliegenden Erfindung;
- Fig. 2: ein Blockschaltbild eines weiteren Ausführungsbeispiels der vorliegenden Erfindung; und
- Fig. 3: ein Zeitverlaufsdiagramm, bei dem Zeitintervalle verschiedener Betriebszustände und Zeitintervalle einer Erfassung von Meßparametern dargestellt sind.

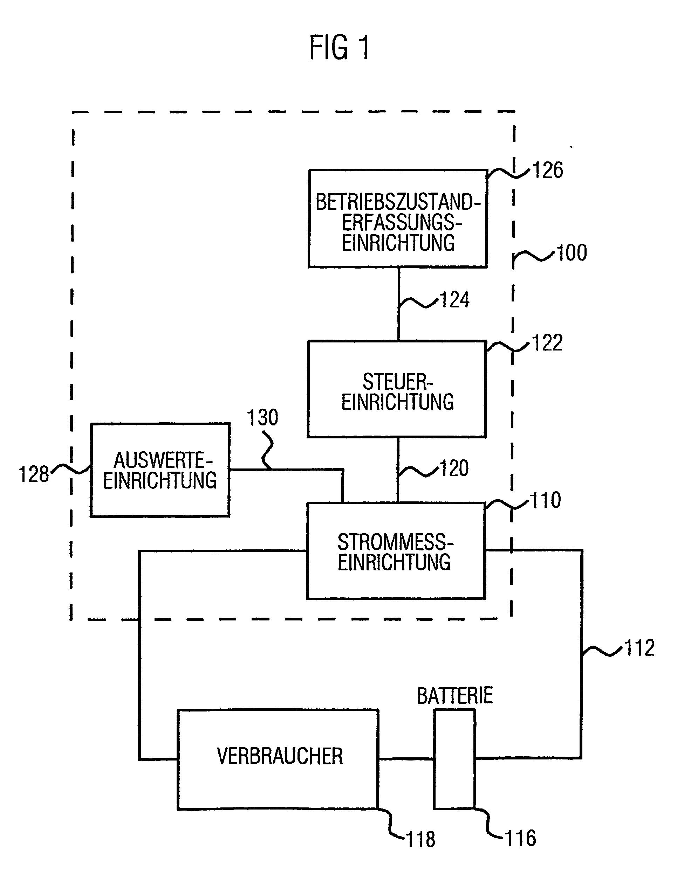

Unter Bezugnahme auf Fig. 1 umfaßt eine Ladezustands-Bestimmungseinrichtung 100 als ein erstes Ausführungsbeispiel der vorliegenden Erfindung eine Strommeßeinrichtung 110, die über eine Leitung 112 mit einem ersten Pol einer Batterie 116 verbindbar ist. Ferner ist die Strommeßeinrichtung 110 über eine Leitung 114 und einen Verbraucher 118 mit einem zweiten Pol der Batterie 116 verbindbar. Die Batterie 116 kann jede bekannte aufladbare oder nichtaufladbare Batterie oder jedes bekannte Batteriepaket umfassen. Beispielsweise kann die Batterie eine Flach-Batterie mit niedriger Gesamtkapazität sein. Bei dem Verbraucher 118 kann es sich um einen einzelnen Verbraucher, wie beispielsweise einen Sendeempfänger, oder mehrere zusammengeschaltete Teil-Verbraucher handeln.

Die Strommeßeinrichtung 110 umfaßt sämtliche bekannte Strommeßeinrichtungen, wie beispielsweise einen elektrischen Widerstand, an dem eine elektrische Spannung abgegriffen wird, oder kontaktlose Strommeßeinrichtungen, bei denen die Größe des Stroms beispielsweise über ein magnetisches Feld bestimmt wird.

Die Strommeßeinrichtung 110 ist über eine Leitung 120 zum Empfangen von Steuersignalen mit einer Steuereinrichtung 122 verbunden. Weiterhin ist die Steuereinrichtung 122 über eine Leitung 124 mit einer Betriebszustands-Erfassungseinrichtung 126 verbunden. Die Ladezustands-Bestimmungseinrichtung 100 weist ferner eine Auswerteeinrichtung 128 auf, die über eine Leitung 130 mit der Strommeßeinrichtung 110 verbunden ist.

Im Betrieb wird der Verbraucher 118 über den Versorgungsstromkreis, der die Leitungen 112 und 114 umfaßt, von der Batterie 116 über die Leitungen 112 und 114 mit elektrischer Leistung versorgt. Der Verbraucher 118 weist typischerweise mehrere Betriebszustände auf, die jeweils unterschiedliche Verbrauchsleistungen umfassen. Beispielsweise kann der Verbraucher 118 ein Sendeempfänger sein, bei dem eine Leistungs-Verwaltungs-Einheit eine Empfangsschaltung aktiviert, wenn ein Zentralcomputer Daten erwartet und eine Sendeschaltung aktiviert, wenn dieser Daten versenden will. Ferner kann der Verbraucher 116 durch das Leistungs-Verwaltungs-Modul hinsichtlich einer Verstärkung der Empfangs- und der Sendeschaltung abhängig von einem empfangenen Signalpegel gesteuert werden. Folglich ergibt sich für den Verbraucher 118, je nachdem, welche Komponenten aktiv geschaltet sind und welche Verstärkungswerte eingestellt sind, ein unterschiedlicher Versorgungsstrom.

Im folgenden wird nun erklärt, wie die Abhängigkeit des Versorgungsstroms von einem Betriebszustand des Verbrauchers 118 erfindungsgemäß verwendet wird, um einen Ladungszustand der Batterie 116 zu bestimmen. Typischerweise wird der Betriebszustand des Verbrauchers 118 von einem zentralen Baustein, wie beispielsweise einer zentralen Verarbeitungseinheit (CPU = Central Processing Unit) oder einem Leistungs-Verwaltungs-Modul gesteuert. Dabei bleibt der von der Batterie 116 entnommene Versorgungsstrom im wesentlichen konstant, so lange sich der Betriebszustand des Verbrauchers 118 nicht ändert. Erfindungsgemäß wird dies ausgenützt, indem für einen bestimmten Betriebszustand lediglich über eine kurze Zeit der Versorgungsstrom für den Verbraucher 118 bestimmt wird und daraufhin lediglich die Zeit gemessen wird, während der sich der Verbraucher 118 in dem Betriebszustand befindet. Bei einer Änderung des Betriebszustands des Verbrauchers 118 wird für den neuen Betriebszustand eine kurzzeitige Versorgungsstrommessung durchgeführt und dann wieder lediglich die Zeit, in der der Strom konstant bleibt.

Bei dem Ausführungsbeispiel von Fig. 1 wird dies dadurch erreicht, daß die Betriebszustands-Erfassungseinrichtung 126 einen jeweiligen Betriebszustand des Verbrauchers 118 erfaßt und über die Leitung 124 ein Signal, das den Betriebszustand des Verbrauchers darstellt, an die Steuereinrichtung 122 anlegt.

Die Steuereinrichtung 122 verwendet das von der Betriebszustanderfassungseinrichtung 126 empfangene Betriebszustandssignal, um ein Steuersignal zum Steuern der Strommeßeinrichtung 110 zu erzeugen, so daß dieselbe lediglich dann zum Erfassen des Versorgungsstroms von der Batterie 116 zu dem Verbraucher 118 aktiviert wird, wenn das Betriebszustandssignal auf eine Änderung des Betriebszustands des Verbrauchers 118 hinweist. Nachdem die Strommeßeinrichtung 110 von der Steuereinrichtung 122 zum Erfassen des elektrischen Stroms aktiviert wird, führt dieselbe eine Messung des Versorgungsstroms des Verbrauchers 118 durch.

Vorzugsweise wird die Strommeßeinrichtung 110 lediglich für eine Zeitdauer aktiviert, die ausreichend ist, um eine genaue Erfassung des Versorgungsstroms zu gewährleisten. Für die restliche Zeit, während der der Verbraucher den Betriebszustand beibehält, wird die Strommeßeinrichtung 110 von der Steuereinrichtung 122 in einen deaktivierten Zustand versetzt, so daß die Strommeßeinrichtung 110 selbst keine oder lediglich eine sehr geringe Leistung verbraucht. Folglich verbraucht die Strommeßeinrichtung 110 im wesentlichen nur während des aktivierten Zustands elektrische Leistung, die von der Batterie 116 geliefert wird.

Vorzugsweise sollte die Strommeßeinrichtung unmittelbar nach einer Betriebszustandsänderung zum Messen des Versorgungsstroms aktiviert werden, um ein Erfassen des Stroms auch für den Fall zu gewährleisten, wenn der Verbraucher bereits nach kurzer Zeit in den nächsten Betriebszustand übergeht.

Für das erfindungsgemäße Erfassen des Ladezustands ist es folglich wichtig, eine Signalisierung durch die Betriebszustand-Erfassungseinrichtung, die beispielsweise eine Leistungs-Verwaltungs-Einheit oder eine zentrale Steuereinheit umfassen kann, zu erhalten, wenn sich eine Steuerung des Verbrauchers, beispielsweise bei einer Änderung des Betriebszustands oder einer Versorgungsspannung, ändert. Für die Kommunikation zwischen der den Betriebszustand signalisierenden Betriebszustandserfassungseinrichtung 126 und der Steuereinrichtung 122 kann vorzugsweise ein standardisierter Bus, wie beispielsweise ein SM-Bus (System-Management-Bus), verwendet werden.

Die von der Strommeßeinrichtung 110 während des aktiven Zustands erfaßte Größe des Versorgungsstroms wird nach der Erfassung über die Leitung 130 in die Auswerteeinrichtung 128 eingegeben. Die Auswerteeinrichtung 128 verwendet daraufhin den erfaßten elektrischen Strom, um den Ladezustand der Batterie zu ermitteln. Dazu erfaßt die Auswerteeinrichtung 128 die Zeitdauer über die der Betriebszustand des Verbrauchers 118 beibehalten wird. Die Erfassung der Zeitdauer kann mittels einer bekannten Zeiterfassungseinrichtung erfolgen, wobei eine Zeiterfassung typischerweise einen sehr geringen Strom aufweist, so daß die zur Zeiterfassung benötige Verlustleistung gering gehalten ist.

Das Erfassen der Zeitdauer eines Betriebszustands kann beispielsweise derart erreicht werden, daß ansprechend auf eine von der Betriebszustandserfassungseinrichtung 126 angezeigte Änderung des Betriebszustands eine Zeitmessung aktiviert .wird, die die bis zu einer darauffolgenden Betriebszustandsänderung verstrichene Zeit, d.h. die Zeitdauer zwischen aufeinanderfolgenden Betriebszustandsänderungen, erfaßt.

Ferner kann bei einem alternativen Ausführungsbeispiel die einem jeweiligen Betriebszustand zugeordnete Zeitdauer durch ein Erfassen der zwischen jeweiligen Stromerfassungen verstrichenen Zeit bestimmt werden. Dabei ist jedoch zu berücksichtigen, daß die Strommessung selbst eine gewisse Zeitdauer in Anspruch nimmt, die ferner zeitlichen Schwankungen unterworfen ist.

Nachdem für einen jeweiligen Betriebszustand der Verbrauchsstrom des Verbrauchers 118 und die Zeitdauer des jeweils zugeordneten Betriebszustands erfaßt sind, berechnet die Auswerteeinrichtung 128 einen Ladezustand der Batterie 116. Dazu kann die Ladungsmenge, die von der Batterie 116 während der Beibehaltung des Betriebszustands entnommen wurde, durch eine Multiplikation des erfaßten Stromwerts mit der jeweilig zugeordneten Zeitdauer bestimmt werden, und unter Verwendung eines vorhergehend bestimmten Ladungszustands auf einen aktuellen Ladungszustand geschlossen werden.

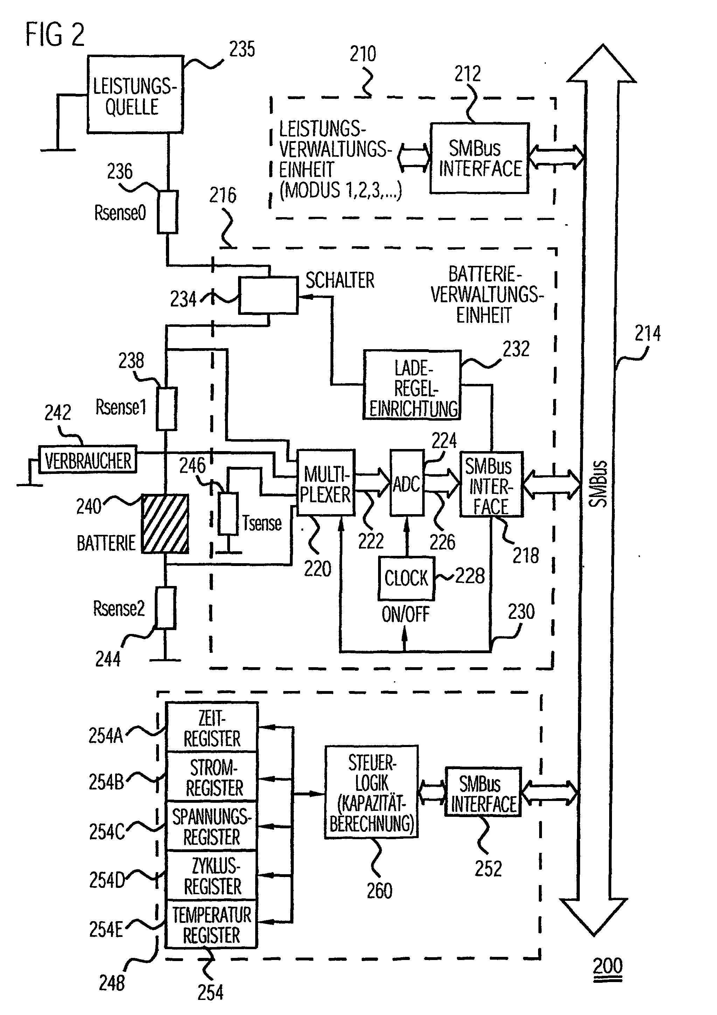

Bei alternativen Ausführungsbeispielen können ein oder mehrere Betriebsparameter der Batterie 116 zusätzlich erfaßt werden, um eine genauere Bestimmung des Ladezustands der Batterie 116 zu ermöglichen, wie es unter Bezugnahme auf Fig. 2 näher erläutert wird. Die zur genaueren Bestimmung erfaßten Betriebsparameter umfassen beispielsweise eine Temperatur und eine Klemmenspannung der Batterie 116.

Bei einem wiederholten Auftreten bestimmter Kombinationen von Betriebszuständen der einzelnen Teilkomponenten ist es bei einem Ausführungsbeispiel vorgesehen, den Stromwert bei dem ersten Auftreten des Betriebszustands zu speichern, so daß aufgrund der Verfügbarkeit des Stromwerts bei einem wiederholten Auftreten des Betriebszustands auf eine Messung des Stroms verzichtet werden kann. Dadurch kann eine Verlustleistung der Batterie weiter reduziert werden.

Vorzugsweise wird bei einem mehrmaligen Auftreten von bestimmten Kombinationen von Betriebszuständen der einzelnen Teilkomponenten der Versorgungsstrom jedoch in bestimmten Abständen neu gemessen, da sich abhängig von der Umgebungstemperatur und der Alterung auch die elektrischen Eigenschaften der Teilkomponenten ändern können, wodurch sich typischerweise auch der Versorgungsstrom verändert.

Dies kann beispielsweise erreicht werden, indem bei einem sich ändernden Betriebszustand zusätzlich bestimmt wird, ob dieser in einem vorbestimmten Zeitintervall aufgetreten ist. Tritt beispielsweise ein Betriebszustand auf, für den bereits ein Stromwert erfaßt wurde, so wird die Zeitdauer bestimmt, die seit der letzten Stromerfassung dieses Betriebszustands verstrichen ist. Daraufhin wird die bestimmte Zeit mit einem vorbestimmten Vergleichswert verglichen. Für den Fall, daß die bestimmte Zeitdauer den Vergleichswert überschreitet, wird eine Stromerfassung durchgeführt, ansonsten nicht.

Das oben beschriebene Verfahren kann auch bei speziellen Leistungs-Verwaltungs-Einheiten angewendet werden, die eine Steuerung des Verbrauchers 118 durchführen, beispielsweise indem die Versorgungsspannung von einzelnen Verbraucherkomponenten während des Betriebs reguliert wird. Hierbei ist es lediglich erforderlich, den Versorgungsstrom bei einer Änderung einer oder mehrerer Versorgungsspannungen neu zu messen, wobei bis zu einer erneuten Änderung lediglich die Zeitdauer des konstanten Stroms erfaßt werden muß. Bei einem Ausführungsbeispiel kann die Auswerteeinrichtung 128 einen jeweiligen Wert der Zeitdauer eines Betriebszustands direkt von einer Leistungs-Verwaltungs-Einheit erhalten. Dies ist insbesondere dann vorteilhaft, wenn die Leistungs-Verwaltungs-Einheit in vorbestimmten Zeitabständen eine Änderung des Betriebszustands des Verbrauchers 118 durchführt, da in diesen Fällen die Zeitdauer des Betriebszustands aus den vorbestimmten Zeitabständen bestimmbar ist.

Unter Bezugnahme auf Fig. 2 wird nachfolgend ein weiteres Ausführungsbeispiel der vorliegenden Erfindung erklärt. Bei diesem Ausführungsbeispiel werden zusätzlich zu dem erfaßten Versorgungsstrom Meßwerte erfaßt, die eine Batterietemperatur und eine Klemmenspannung der Batterie umfassen. Ferner wird eine Speicherung der erfaßten Meßwerte sowie des erfaßten Stromwerts durchgeführt.

Gemäß Fig. 2 umfaßt eine Ladezustands-Bestimmungseinrichtung 200 eine Leistungs-Verwaltungs-Einheit 210, die über eine Busschnittstelle 212 mit einer Busleitung 214 verbunden ist. Die Ladezustands-Bestimmungseinrichtung 200 umfaßt ferner eine Batterieverwaltungseinheit 216, die über eine Busschnittstelle 218 mit der Busleitung 214 verbunden ist. Die Batterieverwaltungseinheit 216 weist ferner einen Multiplexer 220 auf, der über eine Leitung 222 mit einem Analog-Digital-Wandler (ADC) 224 verbunden ist. Der Analog-Digital-Wandler 224 ist ferner über eine Leitung 226 mit der Schnittstelle 218 verbunden.

Die Schnittstelle 218 ist mit einer Taktsignaleinheit 228 und mit dem Multiplexer 220 über eine Leitung 230 verschaltet. Die Taktsignaleinheit 228 weist ferner eine Verbindung mit dem Analog-Digital-Wandler 224 auf. Ferner ist die Schnittstelle 218 mit einer Ladungsregeleinheit 232 verbunden, die wiederum mit einem Schalter 234 verbunden ist. Ein Eingang des Schalters 234 ist über einen Widerstand 236 mit einer Leistungsquelle 235 verschaltet, die ein Aufladen der Batterie während eines Ladungsvorgangs ermöglicht. Ein Ausgang des Schalters 234 ist ferner über einen Widerstand 238 mit einem ersten Pol einer Batterie 240 verbunden.

Der erste Pol der Batterie 240 ist mit einem Verbraucher 242 verbunden, der ferner eine Verbindung zu Masse aufweist. Der zweite Pol der Batterie 240 ist über einen Widerstand 244 ebenfalls mit Masse verbunden, so daß sich ein Verbraucherstromkreis ergibt, bei dem ein Strom von dem ersten Pol der Batterie 240 zu dem Verbraucher 242 und von demselben über die Masseleitung zu dem zweiten Pol der Batterie 240 fließen kann.

Ferner ist der zweite Pol der Batterie 240 mit einem ersten Eingang des Multiplexers 220 verbunden. Der Multiplexer 220 weist erste bis vierte Eingänge auf, wobei ein erster Eingang des Multiplexers 220 mit dem zweiten Pol der Batterie 240 und ein zweiter Eingang des Multiplexers 220 mit einem Temperaturerfassungselement 246 verbunden ist, während ein dritter Eingang des Multiplexers mit dem ersten Pol der Batterie 240 verschaltet ist. Ferner ist ein vierter Eingang des Multiplexers 220 mit einem Punkt verbunden, der auf der Verbindungsleitung zwischen dem Widerstand 238 und dem Schalter 234 angeordnet ist.

Die Ladungszustands-Bestimmungseinrichtung 200 weist ferner eine Auswerteeinheit 248 auf, die über eine Schnittstelle 250 mit der Busleitung 214 verbunden ist. Die Schnittstelle 250 ist mit einer Recheneinheit 252 verbunden, die wiederum mit einer Registeranordnung 254 verschaltet ist. Die Registeranordnung 254 umfaßt fünf Register, die derart mit der Recheneinheit 252 verbunden sind, daß die Recheneinheit 252 einen Ausgabewert in ein ausgewähltes Register schreiben und aus einem ausgewählten Register gespeicherte Werte in die Recheneinheit 252 laden kann. Die Register werden verwendet, um erfaßte Parameter, die eine Betriebszustands-Zeitdauer, einen Verbraucherstrom, und eine Klemmenspannung und umfassen, für jeden auftretenden Betriebszustand zu speichern, wie es nachfolgend noch genauer erklärt wird. Dabei ist jeweils ein Register einem Parameter zugeordnet.

Im folgenden wird ein möglicher Betrieb der Ladezustands-Bestimmungseinrichtung 200 erläutert. Im Betrieb steuert die Leistungs-Verwaltungs-Einheit 210 den Verbraucher 242, der beispielsweise einen Sendeempfänger umfaßt. Dabei aktiviert die Leistungs-Verwaltungs-Einheit 210 eine Empfangsschaltung des Sendeempfängers, wenn ein Zentralcomputer Daten erwartet. Ferner wird eine Sendeschaltung aktiviert, wenn Daten versendet werden sollen. Die Leistungs-Verwaltungs-Einheit 210 steuert ferner eine Verstärkung der Empfangs- und der Sendeschaltung, die abhängig von dem empfangenen Signalpegel eingestellt wird.

Daher ergeben sich, abhängig davon, welche Komponenten gerade aktiv sind und welche Verstärkungswerte eingestellt sind, unterschiedliche Betriebszustände des Sendeempfängers, die jeweils unterschiedliche Versorgungsströme aufweisen, die von der Batterie 240 geliefert werden.

Bei dem beschriebenen Ausführungsbeispiel gibt die Leistungs-Verwaltungs-Einheit 210 jedesmal, wenn eine Aktivierung bzw. Deaktivierung der Sende- oder Empfangsschaltung oder eine Umschaltung der Verstärkung einer Komponente des Sendeempfängers durchgeführt wird, ein Informationssignal über die Schnittstelle 212 und die Busleitung 214 an die Schnittstelle 218 der Batterie-Verwaltungs-Einheit 216 aus. Das Informationssignal meldet der Batterie-Verwaltungs-Einheit 216 die jeweilige Veränderung mit einer genauen Identifizierung. Die Identifizierung kann beispielsweise die Komponenten mit den zugeordneten Betriebszuständen oder lediglich eine Nummer umfassen, die einem bestimmten Betriebszustand zugeordnet ist. Die Meldung einer Veränderung des Betriebszustands bewirkt, daß die Batterie-Verwaltungs-Einheit 216 von einem deaktivierten Zustand in einen aktivierten Zustand versetzt wird. Die Schnittstelle 218 veranlaßt daraufhin, daß eine Temperatur der Batterie 240, eine Klemmenspannung und ein Versorgungsstrom von der Batterie 240 zu dem Verbraucher 242 gemessen wird. Die Messung der Parameter wird vorzugsweise nacheinander und in kurzeitigen Zeitintervallen durchgeführt.

Die Messungen werden derart durchgeführt, daß die Schnittstelle 218 über die Leitung 230 den Multiplexer 220 steuert, so daß jeweilige Eingänge desselben aktiviert werden. Beispielsweise wird zur Messung einer Temperatur der zweite Eingang des Multiplexers 220, der mit dem Temperaturelement 246 verbunden ist, aktiviert. Dadurch wird eine an dem Temperaturelement 246 anliegende Spannung, die auf die Batterietemperatur hinweist, durch den Multiplexer 220 an den Analog-Digital-Wandler 222 angelegt. Der Analog-Digital-Wandler wandelt den Spannungswert in einen digitalen Wert um, der daraufhin über die Schnittstelle 218 und die Busleitung 214 der Auswerteeinheit 248 zugeführt wird.

Zur Erfassung einer Klemmenspannung der Batterie 240 wird der Multiplexer 220 von der Schnittstelle 218 gesteuert, um den ersten Eingang des Multiplexers, der mit dem zweiten Pol der Batterie 240 verbunden ist, und den dritten Eingang des Multiplexers, der mit dem ersten Pol der Batterie 240 verbunden ist, zu aktivieren, so daß eine Differenzspannung des ersten und zweiten Pols, die der Klemmenspannung der Batterie 240 entspricht, in den Analog-Digital-Wandler 224 eingegeben wird. Der Analog-Digital-Wandler 224 erzeugt aus der angelegten Klemmenspannung einen digitalen Wert, der auf die Klemmenspannung hinweist, und überträgt denselben über die Busleitung 240 zu der Auswerteeinheit 248.

Ferner wird bei einer Strommessung des Verbraucherstroms der erste Eingang des Multiplexers 220 aktiviert, wodurch ein Strom, der von dem ersten Pol der Batterie zu dem Verbraucher und von dem Verbraucher über Masse zurück zu der Batterie fließt, mittels eines Spannungsabfalls an dem dritten Widerstand 244 erfaßbar ist. Durch das Aktivieren des ersten Eingangs wird die durch den Verbraucherstrom verursachte Spannung an dem dritten Widerstand 244 durch den Multiplexer 220 an den Analog-Digital-Wandler 224 angelegt. Ansprechend auf die angelegte Spannung erzeugt der Analog-Digital-Wandler 224 wiederum einen digitalen Wert, der auf den Versorgungsstrom der Batterie 240 hinweist. Der digitale Stromwert wird daraufhin der Auswerteeinheit 248 zugeführt.

Nachdem die Messungen durchgeführt sind, geht die Batterieverwaltungseinheit 216 wieder in einen deaktivierten Zustand über, bei dem lediglich eine Zeitmessung durch die Zeiterfassungsvorrichtung 228 durchgeführt wird. Die Zeiterfassungsvorrichtung wird ansprechend auf die Meldung einer Veränderung des Betriebszustands des Verbrauchers durch die Schnittstelle 218 zum Erfassen der zeitlichen Dauer des Betriebszustands in Gang gesetzt. Die Zeitmessung wird mit einer nächsten Meldung einer Betriebszustandsänderung beendet, wobei gleichzeitig die nächste Zeiterfassung für den geänderten Betriebszustand gestartet wird. Die von der Zeiterfassungsvorrichtung 228 ermittelte Zeitdauer wird in den Analog-Digital-Wandler 224 eingegeben und daraufhin über die Busleitung 214 zu der Auswerteeinheit 248 übertragen.

Bei dem beschriebenen Ausführungsbeispiel werden die von der Batterie-Verwaltungs-Einheit 216 ermittelten Meßwerte nach dem Erfassen in den jeweiligen Registern der Registeranordnung 254 gespeichert. Genauer gesagt, wird die Betriebszustands-Zeitdauer in einem Register 254a, der Verbraucherstrom in einem Register 254b und die Klemmenspannung in dem Register 254c gespeichert. Das Register 254d speichert ferner die Anzahl der vollständigen Entladezyklen. Da sich die Kapazität mit der Batteriealterung, also mit der Anzahl der Entladezyklen verringert, wird dieser Wert zur Korrektur der Gesamtkapazität verwendet. Ferner wird ein Wert der Batterietemperatur in einem Register 254e gespeichert.

Unter Verwendung des Betriebszustands-Zeitdauer und den zugeordneten Spannungs-, Temperatur- und Strommeßwerten berechnet daraufhin die Recheneinheit 252 eine neue Restkapazität der Batterie 240.

Nach dem Erfassen der obigen Werte und dem darauffolgenden Berechnen eines neuen Ladungszustands gehen die Auswerteeinheit 248 und die Batterie-Verwaltungs-Einheit 216 in einen deaktivierten Zustand über, bei dem lediglich die Zeiterfassungsvorrichtung 228 zur Erfassung einer Zeitdauer des momentanen Betriebszustands aktiv geschaltet ist. Da die Zeiterfassungseinrichtung 228, die beispielsweise eine interne Uhr umfassen kann, typischerweise eine sehr geringe Leistung verbraucht, stellt der deaktivierte Zustand einen stromsparenden Modus dar.

Ein Aktivieren der Batterie-Verwaltungs-Einheit 216 von dem deaktivierten Zustand zu dem aktivierten Zustand wird lediglich mit einer neuen Veränderung des Betriebszustands eines oder mehrere Teilkomponenten des Verbrauchers durchgeführt. Dabei erfolgt die Meldung der Veränderung des Betriebszustands auf die bereits oben beschriebene Weise durch die Leistungs-Verwaltungs-Einheit 210. Ist dieser neue Betriebszustand oder die Kombination mehrerer Betriebszustände noch nicht aufgetreten, so werden wiederum alle drei Messungen, d. h. eine Temperatur-, eine Spannung- und eine Strommessung, durchgeführt.

Ist dagegen der neue Betriebszustand oder die Kombination mehrerer Betriebszustände schon einmal aufgetreten, so wird eine Strommessung nicht durchgeführt, da der bereits früher erfaßte Stromwert, der diesem Betriebszustand zugeordnet ist, in der Registeranordnung 254 gespeichert ist, und zur Berechnung in der Recheneinheit 252 geladen werden kann. In diesem Fall wird die Batterie-Verwaltungs-Einheit 216 nach einer Erfassung der Temperatur und der Klemmenspannung wieder in den deaktivierten Zustand versetzt. Aufgrund der Beschränkung der Aufgaben der erfindungsgemäßen Batterieladungszustands-Bestimmungseinrichtung kann eine durch die Batterie-Verwaltungs-Einheit verursachte Verlustleistung einer Batterie erheblich reduziert werden. Dies ermöglicht, daß eine Ladungszustandsbestimmung auch für sehr geringe Batteriekapazitäten und sehr lange Betriebszeiten möglich ist.

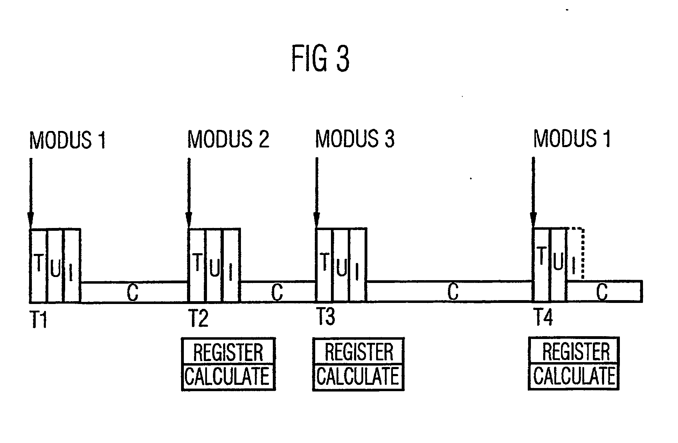

Unter Bezugnahme auf Fig. 3 wird das oben erklärte Verfahren anhand eines Zeitdiagramms nun näher erläutert. Zu einem ersten Zeitpunkt T1 schaltet die Leistungs-Verwaltungs-Einheit (PM) den Verbraucher in einen ersten Modus. Daraufhin wird nach einer Meldung durch die Leistungs-Verwaltungs-Einheit an die Batterie-Verwaltungs-Einheit ein aufeinanderfolgendes Erfassen einer Temperatur T, einer Klemmenspannung U und eines Verbraucherstroms I durchgeführt und die erfaßten Werte in jeweiligen Registern gespeichert. Ferner wird zu dem Zeitpunkt T1 eine Messung einer Zeit C bis zu der nächsten Änderung eines Betriebszustands gestartet.

Zu einem Zeitpunkt T2 bewirkt die Leistungs-Verwaltungs-Einheit 210 eine Veränderung des Verbrauchers von dem ersten Betriebszustand (Modus 1) zu einem zweiten Betriebszustand (Modus 2). Ansprechend auf die Meldung dieser Veränderung wird die Zeitmessung des ersten Betriebszustands (Modus 1) beendet, die erfaßte Zeitdauer in der Registeranordnung 254 gespeichert und unter Verwendung der bereits vorher gespeicherten Temperatur-, Klemmenspannung- und Verbraucherstromwerte der neue Ladungszustand der Batterie 240 berechnet. Ferner wird zu dem Zeitpunkt T2 eine aufeinanderfolgende Messung der Meßparameter, d.h. der Temperatur, der Klemmenspannung und des Versorgungsstroms, für den zweiten Betriebszustand gestartet. Nach der Erfassung werden die Meßwerte in der Registereinheit 254 gespeichert. Ebenso beginnt zu dem Zeitpunkt T2 die Erfassung der Zeitdauer des zweiten Betriebszustands (Modus 2) durch die Zeiterfassungsvorrichtung 226.

Zu einem dritten Zeitpunkt T3 schaltet die Leistungs-Verwaltungs-Einheit 210 den Verbraucher in einen dritten Betriebszustand (Modus 3). Die Zeitmessung für den vorhergehenden Betriebszustand (Modus 2) wird beendet, der Messwert in die zugeordnete Registereinheit geschrieben und unter Verwendung der in den Registereinheiten gespeicherten Werten, die dem zweiten Betriebszustand (Modus 2) zugeordnet sind, ein neuer Ladezustand der Batterie 240 berechnet. Ferner wird wiederum die Temperatur-, Klemmenspannung- und Strom-Messung für den dritten Betriebszustand (Modus 3) durchgeführt und die Zeiterfassungsvorrichtung 228 zum Erfassen der Zeitdauer des dritten Betriebszustands (Modus 3) gestartet.

Zu einem Zeitpunkt T4 wird der Verbraucher durch die Leistungs-Verwaltungs-Einheit 210 wieder in den ersten Betriebszustand (Modus 1) versetzt, weshalb für diesen Betriebszustand keine Messung des Verbrauchsstrom durchgeführt wird, da der Verbrauchsstrom für den ersten Betriebszustand (Modus 1) bereits zu einem früheren Zeitpunkt durchgeführt wurde. Wie es in Fig 3. zu erkennen ist, wird daher lediglich eine Temperatur- und Klemmenspannungerfassung durchgeführt sowie die Zeitmessung für den ersten Betriebszustand (Modus 1) gestartet.

Zusätzlich zu der Verwendung des erfaßten Verbraucherstroms ist die Ladezustands-Bestimmungseinrichtung 200 ausgebildet, um ein Aufladen durchzuführen, wenn die Batterie 240 wiederaufladbar ist. Unter erneuter Bezugnahme auf Fig. 2 wird die Batterie 240 über eine Betätigung des Schalters 234 durch die Laderegeleinheit 232 zum Aufladen mit der Leistungsquelle 235 verbunden, so daß während des Aufladevorgangs die Leistungsquelle 235 über den Widerstand 236 und den Widerstand 238 mit dem ersten Pol der Batterie 240 verbunden ist. Ferner ist bei dem Aufladevorgang der zweite Pol der Batterie 240 über Masse mit der Leistungsquelle 235 verschaltet.

Bei jedem vollständigen Ladevorgang wird das Zyklus-Register 254d um einen Wert erhöht. Da sich die Batteriekapazität mit der Anzahl der Lade-Entlade-Zyklen verringert, kann so die Batteriealterung einbezogen werden.

Bei dem Ladevorgang wird der Ladestrom über die an dem zweiten Widerstand 238 abfallende Spannung ermittelt. Dazu wird der vierte Eingang des Multiplexers 220, der mit einem Punkt der Verbindungsleitung zwischen dem zweiten Widerstand 238 und dem Schalter 234 verbunden ist und der dritte Eingang des Multiplexers 220, der mit dem ersten Pol der Batterie 240 verbunden ist, aktiv geschaltet. Die Differenz der an dem dritten und vierten Eingang des Multiplexers 220 anliegenden Spannungen wird an den Analog-Digital-Wandler 224 angelegt. Der Analog-Digital-Wandler 224 wandelt den Spannungswert in einen digitalen Wert um, der auf die Größe des Ladestrom von der Leistungsquelle zu der Batterie 240 hinweist. Der ermittelte Wert wird in die Auswerteeinheit 248 übertragen, so daß die Recheneinheit 252 eine zu der Batterie geflossene Ladungsmenge berechnen kann, wodurch eine Änderung des Ladezustands ermittelt werden kann. Zur genaueren Bestimmung können auch hier weitere Parameter der Batterie 240, wie beispielsweise eine Temperatur oder Klemmenspannung, bestimmt werden.

Bei einer Weiterbildung des in Fig. 3 beschriebenen Ausführungsbeispiels ist es vorgesehen, daß bei einem Unterschreiten einer vorbestimmten Ladungskapazität der Batterie die Leistungs-Verwaltungs-Einheit 210 angewiesen wird, den Verbraucher in einen energiesparenden Betriebszustand zu setzen. Bei diesem energiesparenden Betriebszustand werden die wichtigsten Funktionen des Verbrauchers aufrecht erhalten, während weniger wichtige Funktionen oder Aufgaben nicht ausgeführt werden, um Energie zu sparen und die mögliche Betriebszeit zu verlängern. Vorzugsweise erfolgt die Meldung an die Leistungs-Verwaltungs-Einheit 210 durch die Auswerteeinheit 248, da in demselben auch die Ladungskapazität berechnet wird.

Ferner kann bei einem weiteren Ausführungsbeispiel vorgesehen sein, daß bei einer zu hohen Betriebstemperatur der Batterie die Leistungs-Verwaltungs-Einheit oder eine Systemsteuerung zu einem geeigneten Verhalten veranlaßt werden. Beispielsweise kann die Auswerteeinheit 248 über die Busleitung 214 eine Meldung an die Leistungs-Verwaltungs-Einheit 210 ausgeben, um den Verbraucher in einen energiesparenden Betriebszustand zu versetzen, wie es oben erklärt wurde. Dadurch wird der von der Batterie 240 gelieferte Strom reduziert, wodurch die Betriebstemperatur der Batterie erniedrigt wird und ein Überhitzen der Batterie vermieden werden kann.

Bei einem weiteren Ausführungsbeispiel kann die erfindungsgemäße Ladungszustands-Bestimmungseinrichtung ferner eine Schalteinrichtung umfassen, die es ermöglicht, in einem ersten Modus eine Ladungszustandsbestimmung auf die oben beschriebene erfindungsgemäße Weise durchzuführen, während in einem zweiten Modus eine Ladungszustandsbestimmung ohne eine Zusammenarbeit mit der Leistungs-Verwaltungs-Einheit oder einer zentralen Steuereinheit durchgeführt wird. In dem zweiten Modus kann das Erfassen des Stroms auf eine bekannte Art und Weise durch ein permanentes Messen des Stroms erfolgen. Dies ermöglicht eine flexible Handhabung der Ladungszustands-Bestimmungseinrichtung, die sowohl die erfindungsgemäße Bestimmung als auch eine bekannte permanente Bestimmung der Restkapazität durchführen kann, so daß dieselbe auch ohne ein Erfassen des Betriebszustands betrieben werden kann.

Zum Erreichen einer Flexibilität gegenüber Änderungen der Systemkonfiguration kann ein noch weiteres Ausführungsbeispiel der vorliegenden Erfindung eine Kalibrierungseinrichtung umfassen, so daß bei Verwendung eines zusätzlichen Verbrauchers eine Neukalibrierung in Form einer Strommessung ausgelöst wird, wodurch der neue Verbraucher in Zukunft mitberücksichtigt wird. Durch das Hinzufügen beispielsweise eines neuen Teil-Verbrauchers ändert sich typischerweise für alle Betriebszustande der Verbrauchsstrom. Um bereits erfaßte und gespeicherte Stromwerte an den geänderten Verbraucher anzupassen, wird für einen bestimmten Betriebszustand, für den bereits Stromwerte erfaßt und gespeichert wurden, eine Vergleichsmessung durchgeführt. Liegt beispielsweise für den ersten Betriebszustand ein Stromwert vor, so wird nach dem Hinzufügen des zusätzlichen Verbrauchers eine neue Messung des Verbrauchsstroms durchgeführt. Durch ein Vergleichen der Stromwerte vor dem Hinzufügen des Verbrauchers und nachdem der Verbraucher hinzugefügt ist, läßt sich eine durch den zusätzlichen Verbraucher bewirkte relative Verbrauchsstromänderung ermitteln. Die relative Verbrauchsstromänderung für den einen Betriebszustand kann dabei verwendet werden, um die gespeicherten Stromwerte anderer Betriebszustände neu zu kalibrieren.

## Patentansprüche

1. Einrichtung zum Bestimmen eines Ladezustands einer Batterie (116; 240), mit folgenden Merkmalen:
einer Einrichtung (126; 210) zum Erfassen eines Betriebszustands eines Verbrauchers (118; 242) und zum Erzeugen eines den Betriebszustand darstellenden Signals;
einer Strommeßeinrichtung (110; 220, 224, 244) zum Erfassen eines elektrischen Stroms von der Batterie (116; 240) zu dem Verbraucher (118; 242);
einer Steuereinrichtung (122; 218) zum Ansteuern der Strommeßeinrichtung, der das den Betriebszustand darstellende Signal zugeführt wird, welche die Strommeßeinrichtung (110; 220, 224, 244) lediglich zum Erfassen des elektrischen Stroms aktiviert, wenn das den Betriebszustand darstellende Signal eine Änderung des Betriebszustands angibt; **gekennzeichnet durch**
eine Auswerteeinrichtung (128; 248), die den Ladezustand der Batterie (116; 240) aufgrund des von der Strommeßeinrichtung (110; 220, 224, 244) erfaßten elektrischen Stroms und der zwischen jeweiligen Betriebszustandsänderungen verstrichenen Zeit ermittelt.

2. Einrichtung nach Anspruch 1, die ferner eine Spannungsmeßeinrichtung (220) zum Erfassen eines Spannungswerts der Batterie (116; 240) aufweist; und wobei
die Auswerteeinrichtung (128; 248) ferner ausgebildet ist, um den Ladezustand unter Verwendung des erfaßten Spannungswerts zu ermitteln.

3. Einrichtung nach Anspruch 2, wobei die Spannungsmeßeinrichtung (220) ausgebildet ist, um ein Erfassen der Batteriespannung lediglich bei einer Änderung des Betriebszustands des Verbrauchers (118; 242) durchzuführen.

4. Einrichtung nach einem der Ansprüche 1 bis 3, die ferner eine Temperaturmeßeinrichtung zum Erfassen einer Batterietemperatur aufweist; und wobei
die Auswerteeinrichtung (128; 248) ferner ausgebildet ist, um den Ladezustand unter Verwendung der erfaßten Batterietemperatur zu ermitteln.

5. Einrichtung nach einem Anspruch 4, wobei die Temperaturerfassungseinrichtung ausgebildet ist, um eine Erfassung der Batterietemperatur lediglich durchzuführen, wenn sich ein Betriebszustand des Verbrauchers (118; 242) ändert.

6. Einrichtung nach einem der Ansprüche 1 bis 5, die ferner einen Speicher (254b) zum Speichern eines Werts aufweist, der auf den erfaßten elektrischen Strom hinweist.

7. Einrichtung nach einem der Ansprüche 1 bis 6, die ferner einen Speicher zum Speichern eines oder mehrerer Werte von Parametern aufweist, die aus der Liste ausgewählt sind, die eine Klemmenspannung der Batterie (116; 240), eine Batterietemperatur und die zwischen jeweiligen Betriebszustandsänderungen verstrichene Zeit umfaßt .

8. Einrichtung nach einem der Ansprüche 1 bis 7, bei der die Einrichtung zum Erfassen eines Betriebszustands eine Leistungs-Verwaltungs-Einheit (210) oder eine zentrale Verarbeitungseinheit umfaßt.

9. Einrichtung nach einem der Ansprüche 1 bis 8, die ferner eine Bus-Leitung (214) aufweist, um die Einrichtung (210) zum Erfassen eines Betriebszustands mit der Steuereinrichtung (218) zu verschalten.

10. Einrichtung nach einem der Ansprüche 1 bis 9, bei der die Steuereinrichtung (128; 248) ferner ausgebildet ist, um die Strommeßeinrichtung (110; 220, 224, 244) lediglich dann zum Erfassen des elektrischen Stroms zu aktivieren, wenn der nach der Änderung des Betriebszustands eingenommene neue Betriebszustand bisher noch nicht aufgetreten ist oder ein vorhergehendes Auftreten des neuen Betriebszustands länger als eine vorbestimmte Zeitdauer zurückliegt.

11. Einrichtung nach einem der Ansprüche 1 bis 10, bei der die Auswerteeinrichtung (128; 248) ferner ausgebildet ist, um bei einem Unterschreiten des Ladezustands der Batterie (116; 240) unterhalb eines vorbestimmten Werts ein Signal auszugeben, das den Verbraucher (118; 242) veranlaßt, einen energiesparenden Betriebszustand einzunehmen.

12. Einrichtung nach einem der Ansprüche 1 bis 11, bei der die Auswerteeinrichtung (128; 248) ferner ausgebildet ist, um bei einer zu hohen Betriebstemperatur der Batterie (116; 240) ein Signal auszugeben, das den Verbraucher (118; 242) veranlaßt, einen bestimmten Betriebszustand einzunehmen.

13. Einrichtung nach einem der Ansprüche 1 bis 12, die ferner eine Schalteinrichtung aufweist, um von einem ersten Modus, bei dem die Strommeßeinrichtung (110; 220, 224, 244) von der Steuereinrichtung (122; 218) angesteuert wird, zu einem zweiten Modus umzuschalten, bei dem die Strommeßeinrichtung (110; 220, 224, 244) kontinuierlich den elektrischen Strom erfaßt.

14. Einrichtung nach einem der Ansprüche 1 bis 13, die ferner eine Einrichtung zum Berücksichtigen eines geänderten Verbrauchers (118; 242) aufweist, welche ausgebildet ist, um bei einer Änderung des Verbrauchers (118; 242) zu veranlassen, daß die Strommeßeinrichtung den elektrischen Strom von der Batterie (116; 240) zu dem geänderten Verbraucher (118; 242) erfaßt.

15. Einrichtung nach einem der Ansprüche 1 bis 14, bei der der Verbraucher (118; 242) ein Sendeempfänger ist.

16. Einrichtung nach einem der Ansprüche 1 bis 15, bei der die Strommeßeinrichtung (220, 224, 244) ferner ausgebildet ist, um einen elektrischen Ladestrom von einer Leistungsquelle zu der Batterie (116; 240) zu erfassen; und wobei
die Auswerteeinrichtung (128; 248) ferner ausgebildet ist, um den Ladezustand der Batterie (116; 240) unter Verwendung des erfaßten Ladestroms zu ermitteln.

17. Verfahren zum Bestimmen eines Ladezustands einer Batterie (116; 240) mit folgenden Schritten:
Erfassen eines Betriebszustands eines Verbrauchers (118; 242) und Erzeugen eines den Betriebszustand darstellenden Signals;
Durchführen eines Erfassens eines elektrischen Stroms von der Batterie (116; 240) zu dem Verbraucher (118; 242) lediglich, wenn das den Betriebszustand darstellende Signal eine Änderung des Betriebszustands angibt; **gekennzeichnet durch** die Schritte:
Ermitteln des Ladezustands der Batterie (116; 240) aufgrund des von der Strommeßeinrichtung (110; 220, 224, 244) erfaßten elektrischen Stroms und der zwischen jeweiligen Betriebszustandsänderungen verstrichenen Zeit.

## Claims

1. Means for determining a state of charge of a battery (116; 240), comprising:
means (126; 210) for detecting an operating state of a consumer (118; 242) and for generating a signal representing the operating state;
current measuring means (110; 220, 224, 244) for detecting an electrical current from the battery (116; 240) to the consumer (118; 242);
control means (122; 218) for controlling the current measuring means to which the signal representing the operating state is fed, only activating the current measuring means (110; 220, 224, 244) for detecting the electrical current when the signal representing the operating state indicates a change of the operating state; **characterized by**
evaluating means (128; 248) determining the state of charge of the battery (116; 240) on account of the electrical current detected by the current measuring means (110; 220, 224, 244) and the time elapsed between respective operating state changes.

2. The means according to claim 1, further comprising voltage measuring means (220) for detecting a voltage value of the battery (116; 240); and wherein
the evaluating means (128; 248) is further formed to determine the state of charge using the voltage value detected.

3. The means according to claim 2, wherein the voltage measuring means (220) is formed to only perform a detection of the battery voltage with a change of the operating state of the consumer (118; 242).

4. The means according to one of claims 1 to 3, further comprising temperature measuring means for detecting a battery temperature; and wherein
the evaluating means (128; 248) is further formed to determine the state of charge using the battery temperature detected.

5. The means according to claim 4, wherein the temperature detecting means is formed to only perform a detection of the battery temperature when an operating state of the consumer (118; 242) changes.

6. The means according to one of claims 1 to 5, further comprising a memory (254b) for storing a value referring to the electrical current detected.

7. The means according to one of claims 1 to 6, further comprising a memory for storing one or several values of parameters selected from the list including a terminal voltage of the battery (116; 240), a battery temperature and the time elapsed between respective operating state changes.

8. The means according to one of claims 1 to 7, wherein the means for detecting an operating state includes a power management unit (210) or a central processing unit.

9. The means according to one of claims 1 to 8, further comprising a bus line (214) to connect the means (210) for detecting an operating state to the control means (218).

10. The means according to one of claims 1 to 9, wherein the control means (128; 248) is further formed to only activate the current measuring means (110; 220, 224, 244) for detecting the electrical current when the new operating state adopted after the change of the operating state has not yet occurred or a previous occurrence of the new operating state is more than a predetermined duration ago.

11. The means according to one of claims 1 to 10, wherein the evaluating means (128; 248) is further formed to output, when the state of charge of the battery (116; 240) falls below a predetermined value, a signal causing the consumer (118; 242) to adopt an energy-saving operating state.

12. The means according to one of claims 1 to 11, wherein the evaluating means (128; 248) is further formed to output, at too high an operating temperature of the battery (116; 240), a signal causing the consumer (118; 244) to adopt a certain operating state.

13. The means according to one of claims 1 to 12, further comprising switching means to switch from a first mode where the current measuring means (110; 220, 224, 244) is controlled by the control means (122; 218), to a second mode where the current measuring means (110; 220, 224, 244) detects the electrical current continually.

14. The means according to one of claims 1 to 13, further comprising means for considering a changed consumer (118; 242), formed to cause the current measuring means to detect the electrical current from the battery (116; 240) to the changed consumer (118; 242) when the consumer (118; 242) changes.

15. The means according to one of claims 1 to 14, wherein the consumer (118; 242) is a transceiver.

16. The means according to one of claims 1 to 15, wherein the current measuring means (220, 224, 244) is further formed to detect an electrical charge current from a source of power to the battery (116; 240); and wherein
the evaluating means (128; 248) is further formed to determine the state of charge of the battery (116; 240) using the charge current detected.

17. A method for determining a state of charge of a battery (116; 240), comprising the steps of:
detecting an operating state of a consumer (118; 242) and generating a signal representing the operating state;
performing a detection of an electrical current from the battery (116; 240) to the consumer (118; 242) only when the signal representing the operating state indicates a change of the operating state; **characterized by** the following step:
determining the state of charge of the battery (116; 240) using the electrical current detected by the current measuring means (110; 220, 224, 244) and the time elapsed between respective operating state changes.

## Revendications

1. Dispositif pour déterminer un état de charge d'une batterie (116 ; 240), aux caractéristiques suivantes :
un dispositif (126 ; 210) destiné à détecter un état de fonctionnement d'un utilisateur (118 ; 242) et à générer un signal représentant l'état de fonctionnement ;
un dispositif de mesure de courant (110 ; 220, 224, 244) destiné à détecter un courant électrique de la batterie (116 ; 240) vers l'utilisateur (118 ; 242) ;
un dispositif de commande (122 ; 218) destiné à activer le dispositif de mesure de courant auquel est amené le signal représentant l'état de fonctionnement qui n'active le dispositif de mesure de courant (110 ; 220, 224, 244) pour détecter le courant électrique que lorsque le signal représentant un changement de l'état de fonctionnement indique un changement de l'état de fonctionnement ;
**caractérisé par**
un dispositif d'évaluation (128 ; 248) qui détermine l'état de charge de la batterie (116 ; 240) sur base du courant électrique détecté par le dispositif de mesure de courant (110 ; 220, 224, 244) et du temps écoulé entre les changements d'état de fonctionnement respectifs.

2. Dispositif selon la revendication 1, présentant, par ailleurs, un dispositif de mesure de tension (220) destiné à détecter une valeur de tension de la batterie ({116 ; 240) ; et dans lequel
le dispositif d'évaluation (128 ; 248) est, par ailleurs, réalisé pour déterminer l'état de charge à l'aide de la valeur de tension déterminée.

3. Dispositif selon la revendication 2, dans lequel le dispositif de mesure de tension (220) est réalisé pour n'effectuer une détection de la tension de batterie qu'à un changement de l'état de fonctionnement de l'utilisateur (118 ; 242).

4. Dispositif selon l'une des revendications 1 à 3, présentant, par ailleurs, un dispositif de mesure de température destiné à détecter une température de batterie ; et dans lequel
le dispositif d'évaluation (128 ; 248) est, par ailleurs, réalisé pour déterminer l'état de charge à l'aide de la température de batterie détectée.

5. Dispositif selon la revendication 4, dans lequel le dispositif de détection de température est réalisé pour n'effectuer une détection de la température de la batterie que lorsque change un état de fonctionnement de l'utilisateur (118 ; 242).

6. Dispositif selon l'une des revendications 1 à 5, présentant, par ailleurs, une mémoire (254b) destinée à mémoriser une valeur qui indique le courant électrique détecté.

7. Dispositif selon l'une des revendications 1 à 6, présentant, par ailleurs, une mémoire destinée à mémoriser une ou plusieurs valeurs de paramètres qui sont choisis parmi la liste composée d'une tension à vide de la batterie (116 ; 240), une température de batterie et le temps écoulé entre des changements d'état de fonctionnement respectifs.

8. Dispositif selon l'une des revendications 1 à 7, dans lequel le dispositif destiné à détecter un état de fonctionnement comporte une unité de gestion d'énergie (210) ou une unité de traitement centrale.

9. Dispositif selon l'une des revendications 1 à 8, présentant, par ailleurs, une ligne de collecteur (214) destiné à relier le dispositif (210) destiné à détecter un état de fonctionnement au dispositif de commande (218).

10. Dispositif selon l'une des revendications 1 à 9, dans lequel le dispositif de commande (128 ; 248) est, par ailleurs, réalisé de manière à n'activer le dispositif de mesure de courant (110 ; 220, 224) pour détecter le courant électrique que si le nouvel état de fonctionnement adopté après le changement de l'état de fonctionnement ne s'est pas encore produit jusque là ou si une occurrence précédente du nouvel état de fonctionnement date de plus d'une durée prédéterminée.

11. Dispositif selon l'une des revendications 1 à 10, dans lequel le dispositif d'évaluation (128 ; 248) est, par ailleurs, réalisé de manière à sortir, lorsque l'état de charge de la batterie (116 ; 240) descend au-dessous d'une valeur prédéterminée, un signal qui fait que l'utilisateur (118 ; 242) adopte un état de fonctionnement à économie d'énergie.

12. Dispositif selon l'une des revendications 1 à 11, dans lequel le dispositif d'évaluation (128 ; 248) est réalisé, par ailleurs, de manière à sortir, en cas de température de fonctionnement trop élevée de la batterie (116 ; 240), un signal qui fait que l'utilisateur (118 ; 242) adopte un état de fonctionnement déterminé.

13. Dispositif selon l'une des revendications 1 à 12, présentant, par ailleurs, un dispositif de commutation destiné à commuter d'un premier mode dans lequel le dispositif de mesure de courant (110 ; 220, 224, 244) est activé par le dispositif de commande (122 ; 218), à un deuxième mode dans lequel le dispositif de mesure de courant (110 ; 220, 224, 244) détecte en continu le courant électrique.

14. Dispositif selon l'une des revendications 1 à 13, présentant, par ailleurs, un dispositif destiné à tenir compte d'un utilisateur changé (118 ; 242) qui est réalisé de manière à provoquer que, en cas de changement de l'utilisateur (118 ; 242), le dispositif de mesure de courant détecte le courant électrique de la batterie (116 ; 240) vers l'utilisateur changé (118 ; 242).

15. Dispositif selon l'une des revendications 1 à 14, dans lequel l'utilisateur (118 ; 242) est un émetteur-récepteur.

16. Dispositif selon l'une des revendications 1 à 15, dans lequel le dispositif de mesure de courant (220, 224, 244) est, par ailleurs, réalisé de manière à détecter un courant de charge électrique d'une source d'énergie vers la batterie (116 ; 240) ; et dans lequel
le dispositif d'évaluation (128 ; 248) est, par ailleurs, réalisé de manière à déterminer l'état de charge de la batterie (116 ; 240) à l'aide du courant de charge détecté.

17. Procédé pour déterminer un état de charge d'une batterie (116; 240), aux étapes suivantes consistant à :
détecter un état de fonctionnement d'un utilisateur (118 ; 242) et générer un signal représentant un état de fonctionnement ;
réaliser une détection d'un courant électrique de la batterie (116 ; 240) vers l'utilisateur (118 ; 242) uniquement lorsque le signal représentant l'état de fonctionnement indique un changement de l'état de fonctionnement, **caractérisé par** les étapes consistant à :
déterminer l'état de charge de la batterie (116 ; 240) sur base du courant électrique détecté par le dispositif de mesure de courant (110 ; 220, 224, 244) et du temps écoulé entre des changements d'état de fonctionnement respectifs.
